# EUROPÄISCHE PATENTSCHRIFT

(11) **EP 1 193 756 B1**
(45) Veröffentlichungstag und Bekanntmachung des Hinweises auf die Patenterteilung: **06.04.2005**
(21) Anmeldenummer: 01120778.4
(22) Anmeldetag: 07.09.2001
(51) Int. Cl.: H01L 23/34, H02H 5/04, G05D 23/19, H02H 6/00

(54) **Verfahren für eine Vorrichtung mit Leistungshalbleitern und Vorrichtung**
Method for a device with power semiconductors and an apparatus
Méthode pour un dispositif avec semi-conducteurs de puissance et un dispositif

(30) Priorität: 30.09.2000 DE 10048704
(43) Veröffentlichungstag der Anmeldung: 03.04.2002
(73) Patentinhaber: Sew-Eurodrive GmbH & Co. KG, 76646 Bruchsal (DE)
(72) Erfinder: Hörnle, Klaus, 75038 Oberderdingen (DE)

(56) Entgegenhaltungen:
- DE-A- 3 536 098
- US-A- 4 001 649
- US-A- 4 330 809

## Beschreibung

Die Erfindung betrifft ein Verfahren für eine Vorrichtung mit Leistungshalbleitern und Vorrichtung.

Aus der DE 198 60 762 A1 ist ein Verfahren zum Schutz von Endstufen vor Übertemperatur bekannt, wobei ein Maß für eine Temperatur einer Komponente eines Steuergeräts ermittelt wird. Dabei wird das Verfahren für einen Verbrennungsmotor eingesetzt und nur eine Übertragungsstrecke überwacht.

Viele Umrichter umfassen üblicherweise eine Endstufe, die Leistungshalbleiter aufweist, welche auf einem Chip oder Substrat aufgebracht sind, der oder das mit einem Temperaturfühler über einen niedrigen Wärmewiderstand verbunden ist. Der Chip oder das Substrat ist entweder direkt oder über andere Schichten, wie beispielsweise metallische Platten, Wärmeleitpaste, elektrische Isolierungen oder dergleichen, mit einem Kühlkörper verbunden, der entweder aktiv mittels eines Lüfters oder passiv mittels durch Temperaturdifferenz getriebene Konvektion von Zuluft umströmt wird und Wärme an diese abgibt.

Der Temperaturfühler ist elektrisch mit einer Signalelektronik, die mindestens einen Mikroprozessor umfasst, verbunden, wobei ein Steuer- und Regelverfahren für den Umrichter im Mikroprozessor abgearbeitet wird bzw. der Umrichter nach einem solchen Verfahren betrieben wird.

Das Steuer- und Regelverfahren umfasst auch ein Temperaturmodell, das aus den Betriebsparametern, wie beispielsweise Eingangs-, Ausgangsstrom, Eingangs-, Ausgangsspannung, Zwischenkreisspannung, Ausgangsfrequenz, Betriebsart, Tastverhältnis oder dergleichen, und Geräteparametern, wie Wärmewiderstände, Wärmekapazitäten von einzelnen Komponenten oder Übertragungsstrecken, maximal zulässige Temperaturen, eine Temperaturdifferenz zwischen Temperaturfühler und Leistungshalbleitern, oder dergleichen, errechnet. Durch Addition der vom Temperaturfühler gelieferten Temperatur und dieser Temperaturdifferenz ergibt sich ein Maß für die Temperatur der Leistungshalbleiter.

Von Nachteil ist, dass dabei einige Näherungen gemacht werden müssen, die den zumindest theoretisch existenten Einfluss der Umgebungstemperatur eliminieren, und/oder große Sicherheiten eingerechnet werden müssen.

Diese Näherungen machen beispielsweise die Annahme, dass alle Leistungshalbleiter eine gleichgroße Entfernung und/oder Wärmeübergangswiderstand zum Temperaturfühler oder dessen Messposition auf dem Chip oder Substrat aufweisen.

In dieser Schrift soll unter Temperatur auch immer ein Maß für eine Temperatur verstanden werden, also eine Variable des Steuer- und Regelverfahrens, das im Mikroprozessor ausgeführt wird, ein Spannungswert, ein Stromwert oder ein zur Temperatur proportionaler Wert oder eine Variable, deren Wert immer eindeutig zuordenbar zur jeweiligen Temperatur ist.

Ein weiterer Nachteil ist, dass keine Informationen über weitere Teile zur Verfügung stehen oder nur mit einem enormen Rechenaufwand und hohen Fehlerbandbreite errechenbar sind.

Aus der DE 35 36 098 ist eine Einrichtung zum Überwachen der Temperatur eines elektrischen Bauelements bekannt, bei der allerdings nur eine Temperatur mit einem Temperatursensor gemessen wird, nämlich Temperatur des Kühlmediums (Spalte 1, Zeile 11). Daraus wird unter Verwendung von Strom-Messwerten eine Temperatur der Leistungshalbleiter ermittelbar und überwachbar. Allerdings ist somit bei Verschlechterung des Wärmewiderstandes vom Leistungshalbleiter zum Kühlmedium keine Detektionsmöglichkeit vorhanden und eine fehlerhaft bestimmte Temperatur kann auftreten.

Aus der US 4 001 649 ist eine Temperaturüberwachung bei Halbleitern bekannt, bei der ebenfalls die Umgebungstemperatur gemessen wird und aus den Strom-Messwerten auf die Temperatur der Halbleiter geschlossen wird. Nachteiligerweise ist auch hier wiederum eine Verschlechterung des genannten Wärmewiderstandes zur Umgebung hin nicht detektierbar. Auch aus der US 4 330 809 ist ein solches Vorgehen speziell für einen Transistor bekannt.

Der Erfindung liegt daher die Aufgabe zugrunde, ein Steuer- und Regelverfahren weiterzubilden , wobei mehr Information über den Umrichter kostengünstig und in einfacher Weise erstellbar ist und für die Steuerung und Regelung, insbesondere eines Umrichters mit Leistungselektronik, verwendbar ist.

Erfindungsgemäß wird die Aufgabe bei dem Verfahren nach den in Anspruch 1 angegebenen Merkmalen und bei einer Vorrichtung zur Verwendung bei einem solchen Verfahren nach den in Anspruch 10 angegebenen Merkmalen gelöst.

Wesentliche Merkmale der Erfindung bei dem Verfahren sind, dass bei dem Verfahren eine Temperatur wenigstens einer Komponente der Vorrichtung und/oder der Umgebung und/oder der Zuluft direkt oder indirekt ermittelt wird und bei dem Verfahren Aktionen gestartet werden, wenn die Temperatur einen vorgebbaren oder vorgegebenen Schwellwert überschreitet, und bei dem Verfahren ein Temperaturmodell verwendet wird, das zumindest die Temperatur der Umgebung des Kühlkörpers und/oder Zuluft für den Kühlkörper, einen Betriebsparameter und einen Geräteparameter berücksichtigt und Temperaturdifferenzen und/oder Temperaturen errechnet. Wesentlicher Vorteil ist dabei, dass nicht nur eine Übertragungsstrecke von den Leistungshalbleitern zu dem ersten Temperatursensor überwachbar ist sondern auch eine Übertragungsstrecke zu einem zweiten Temperatursensor, der die Temperatur der Umgebung oder Zuluft misst. Somit ist insbesondere die zweite Übertragungsstredce zur Umgebung hin überwachbar. Verschlechterte Wärmeübergänge, verschmutzte Kühlkörper oder defekte Lüfter sind somit zumindest in ihrer Gesamtheit überwachbar.

Bei einer vorteilhaften Ausgestaltung wird eine errechnete Temperatur mit einer gemessenen Temperatur verglichen und es werden bei Überschreiten oder Unterschreiten eines Bereichs um die gemessene Temperatur herum die Aktionen gestartet. Von Vorteil ist dabei, dass kritische Werte angebbar sind. Insbesondere sind sogar mehr kritische Werte derart angebbar, dass zuerst bei Überschreiten der Bereichsgrenze eine Warnung auslösbar ist und bei weiterer Zunahme oder Entfernung von dieser Bereichsgrenze eine weitere Bereichsgrenze eines weiteren Bereichs überschritten wird, wodurch dann eine Fehlermeldung auslösbar und/oder ein Reduzieren der Betriebsfrequenz ausführbar ist. Beim Überschreiten einer nächsten Bereichsgrenze ist dann ein Abschalten des Umrichters ausführbar.

Bei einer vorteilhaften Ausgestaltung umfassen die Aktionen das Ausschalten des Umrichters, Maßnahmen zur Abkühlung und/oder Begrenzung eines weiteren Temperaturanstiegs oder das Abgeben von Warnmeldungen. Von Vorteil ist dabei, dass die Aktionen verschiedene Kategorien umfassen, also nicht nur Abschalten des Umrichters sondern auch bloße Warnmeldungen oder kleine Eingriffe wie Reduzieren der Betriebsfrequenz umfassen.

Bei einer vorteilhaften Ausgestaltung wird aus dem Vergleich der errechneten Temperatur, die sich durch Berücksichtigung der Verlustleistung der Leistungshalbleiter und unter Berücksichtigung der Betriebsparameter und der Umgebungstemperatur ergibt, mit der tatsächlich sich einstellenden Temperatur ein Kriterium zum Auslösen von Schutzmaßnahmen und/ oder Warnmeldungen oder dergleichen hergeleitet. Von Vorteil ist dabei, dass eine theoretisch berechnete Größe mit einer gemessenen Größe vergleichbar ist und somit in kostengünstiger und einfacher Weise eine Überwachung ermöglicht ist.

Bei einer vorteilhaften Ausgestaltung werden die Warnmeldungen elektronisch, elektronisch über einen Feldbus, optisch, akustisch oder elektromagnetisch abgegeben. Von Vorteil ist dabei, dass vorsorgliche Maßnahmen einleitbar sind und nicht direkt und sofort der Umrichter mit Fehlermeldung ausgeschaltet werden muss, also nicht mehr betreibbar ist.

Bei einer vorteilhaften Ausgestaltung wird für das Temperaturmodell eine erste Temperatur an einer ersten Position in der Vorrichtung mit einem ersten Temperatursensor ermittelt und eine zweite Temperatur an einer zweiten Position mit einem zweiten Temperatursensor ermittelt und die erste und zweite Position derart gewählt ist, dass die erste Position einen geringeren Wärmeleitwiderstand zu den Leistungshalbleitern jeweils aufweist als der Wärmeleitwiderstand von der zweiten Position zu den Leistungshalbleitern jeweils. Von Vorteil ist dabei, dass zwei Übertragungsstrecken überwachbar sind und somit unterschiedliche Komponenten überwachbar sind.

Bei einer vorteilhaften Ausgestaltung ist die zweite Position derart gewählt, dass im Wesentlichen die Temperatur der Umgebung oder Temperatur der Zuluft, insbesondere bei Einsatz eines Lüfters, mit dem zweiten Temperatursensor gemessen wird. Von Vorteil ist dabei, dass die entsprechende Übertragungsstrecke für die Wärmeableitung sogar bis zum Niveau der Umgebung hin überwachbar ist.

Bei einer vorteilhaften Ausgestaltung wird
- im Temperaturmodell aus Betriebsparametern und Geräteparametern die Veriustleistung der Leistungshalbleiter errechnet,
- aus den Geräteparametem des Kühlkörpers und der errechneten Verlustleistung des Leistungshalbleiters die Temperaturdifferenz, die sich am Kühlkörper einstellen sollte, errechnet,
- durch Addition der zweiten Temperatur und der errechneten Temperaturdifferenz eine Solltemperatur ermittelt und
- die erste Temperatur mit der errechneten Solltemperatur verglichen. Von Vorteil ist dabei, dass mittels der Kenntnis der Geräteparameter, die ab der Konstruktion und Fertigung bekannt sind, und mit Kenntnis der Betriebsparameter, die der Umrichtersoftware während des Betriebs bekannt sind, in einfacher Weise ein Wert für die Temperatur berechenbar ist und in kostengünstiger Weise mit dem gemessenen Wert vergleichbar ist. Da die thermische Zeitkonstante bei Leistungshalbleitem in industriellen Umrichtern im Bereich von einigen 100 ms liegt, beispielsweise 200 ms, und die Berechnung der Temperatur in der gleichen Weise wie die Zeitschritte der bei industriellen Umrichtern üblichen Berechnungsmethoden unter Verwendung von Mikroprozessoren, beispielsweise 1 ms, ausführbar ist, ist eine Echtzeit-Berechnung für die Temperatur mittels des erfindungsgemäßen Temperaturmodells ausführbar.

Bei einer vorteilhaften Ausgestaltung wird mittels dieses Vergleichs unter Berücksichtigung der thermischen Zeitkonstanten der Vorrichtung eine Überwachung der Vorrichtung durchgeführt. Von Vorteil ist dabei, dass eine Echtzeit-Berechnung in sehr guter Näherung ausführbar ist, da die Zeitschritte für die Berechnung um mindestens eine Größenordnung kleiner sind als die typische thermische Zeitkonstante eines Kühlkörpers eines industriellen Umrichters.

Wesentliche Merkmale der Erfindung bei dem Verfahren sind, dass eine erste Temperatur an einer ersten Position in der Vorrichtung mit einem ersten Temperatursensor messbar ist und eine zweite Temperatur an einer zweiten Position mit einem zweiten Temperatursensor messbar ist und die erste und zweite Position derart gewählt ist, dass die erste Position einen geringeren Wärmeleitwiderstand zu den Leistungshalbleitern jeweils aufweist als der Wärmeleitwiderstand von der zweiten Position zu den Leistungshalbleitern jeweils. Wesentlicher Vorteil ist dabei, dass abhängig von den Positionen die entsprechenden Übertragungsstrecken einfach und kostengünstig überwachbar sind.

### Bezugszeichenliste

- 1: Überwachung und Auswertung
- 2: Ansteuerung
- 3: Sollwert für Motorsteuerung
- 4: Strommessung
- 5: Ansteuersignale
- 6: Kühlkörper
- 7: Lüfter
- 8: Motor
- 9: Warnmeldung oder Wartungsmeldung
- 10: Umrichter
- 13: Gleichrichter
- 14: Spannungsmessung
- 15: Zuluft
- 16: Leistungshalbleiter
- 17: Chip oder Substrat
- T1: erster Temperatursensor
- T2: zweiter Temperatursensor

Die Erfindung wird nun anhand von einer Abbildung näher erläutert:

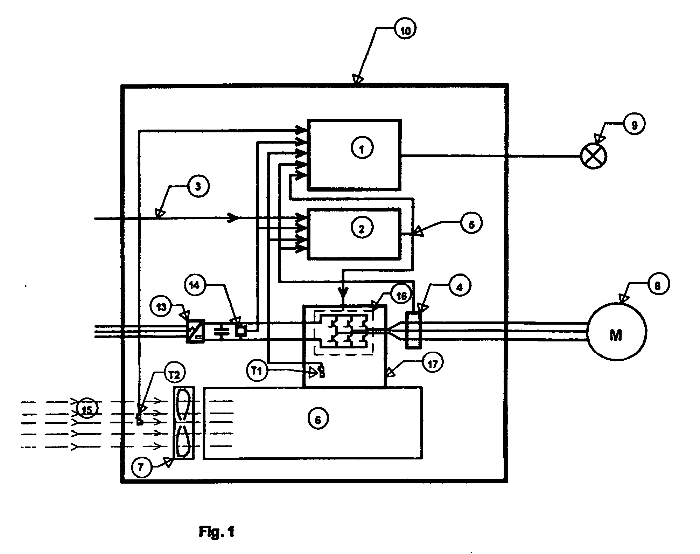

In der Figur 1 ist ein erfindungsgemäßes Ausführungsbeispiel schematisch skizziert. Der Leistungsteil eines Umrichters 10 weist Leistungshalbleiter 16 auf. In diesen Leistungshalbleitern 16 entsteht beim Betrieb Verlustleistung, die zumindest von den unterschiedlichen Betriebsparametern abhängt. Die Betriebsparameter umfassen den elektrischen Strom, der durch die Leistungshalbleiter 16 fließt und mittels einer Strommessung 4 erfasst wird, die elektrische Spannung, die mittels der Gleichrichter 13 gleichgerichtet wird und an den Leistungshalbleitern 16 als mittels der Spannungsmessung 14 erfasste Zwischenkreisspannung anliegt, und Schalthäufigkeit und Betriebsart der Leistungshalbleiter 16, die von der Ansteuerung 2 mittels der Ansteuersignale 5 bestimmt ist, solange kein Defekt oder eine Unregelmäßigkeit vorliegt. Die Ansteuerung 2 berücksichtigt wesentlich den Sollwert 3 für Motorsteuerung, der aus dem Steuer- und Regelverfahren für den Umrichter geliefert wird.

Zum Betreiben eines Elektromotors 8 mit dem Umrichter 10, liegen die Betriebsparameter und die Geräteparameter als Parameter oder Variablen dem im Mikroprozessor ausgeführten Steuer- und Regelverfahren des Umrichters vor oder werden ermittelt. Zu den Geräteparametern zählen auch Wärmewiderstände, Wärmekapazitäten von Komponenten des Umrichters. Besonders wichtig sind dabei die erste Übertragungsstrecke für Wärme von den Leistungshalbleitern 16 zum ersten Temperatursensor T1 und die zweite Übertragungsstrecke für Wärme von den Leistungshalbleitern 16 zum zweiten Temperatursensor T2. Der ersten Übertragungsstrecke ist dabei ein sehr kleiner, effektiver Wärmewiderstand zuordenbar, der viel kleiner, insbesondere um mehr als eine Größenordnung, ist als der effektive Wärmewiderstand der zweiten Übertragungsstrecke. In guter Näherung misst der Temperatursensor T1 die Temperatur der Leistungshalbleiter 16 und der zweite Temperatursensor T2 die Temperatur der Zuluft für den Lüfter 7, also die vom Lüfter 7 angesaugte und auf den Kühlkörper 6 zur Wärmeabfuhr gerichtete Luft.

Ein in dem Steuer- und Regelverfahren angewendetes Temperaturmodell berechnet aus Strom, Spannung und Ansteuersignalverlauf an den Leistungshalbleitem 16, wie auch Schalthäufigkeit, Tastverhältnis, Frequenz, Betriebsart oder dergleichen, nach Ermittlung einer Verlustleistung, die von den Leistungshalbleitern 16 abgegeben wird und zum größten Teil über den Chip oder das Substrat 17 fließt, Temperaturdifferenzen und/oder Temperaturen. Der Temperatursensor T1 befindet sich ebenfalls auf dem Chip oder Substrat 17 und ist somit gut wärmeleitend verbunden mit den Leistungshalbleitern 16. Die Wärme fließt über eine zweite Übertragungsstrecke, die bei verschiedenen erfindungsgemäßen Ausführungsbeispielen verschieden aufgebaut sein und mehrere Schichten umfassen kann, wie beispielsweise Aluminiumplatten, mit Wärmeleitpaste ausgeführte Kontaktschichten oder dergleichen, auf den Kühlkörper 6.

Je nach erfindungsgemäßem Ausführungsbeispiel berücksichtigt das Temperaturmodell im Wärme-Ersatzschaltbild nicht nur alle Wärmewiderstände der Komponenten sondern auch die Wärmekapazitäten der Komponenten. Je nach verwendeter Näherung oder Genauigkeitsforderung werden Wärmekapazitäten oder -widerstände weggelassen oder es wird manchen ein unendlich großer Wert zugeordnet. Die Leistungshalbleiter stellen die Wärmequelle dar, die Umgebung die Wärmesenke. Die hier beschriebenen Übertragungsstrecken sind nur die beiden wesentlichen Übertragungsstrecken. Für die weiteren Übertragungsstrecken gilt immer das in analoger Weise übertragene.

Der Lüfter 7 leitet die angesaugte Umgebungsluft oder Zuluft 15 auf den Kühlkörper 6, wobei mit dem Temperatursensor T2 die Temperatur der Zuluft 15 ermittelt wird.

Die Geräteparameter, wie Wärmekapazität und Wärmewiderstände oder dergleichen, werden bei Konstruktion, Fertigung und/oder Montage bestimmt, beispielsweise durch Ausmessen des Kühlkörpers 6. Ebenso sind die thermischen Übergangswiderstände der Leistungshalbleiter 16 bekannt oder ermittelbar.

Bei anderen erfindungsgemäßen Ausführungsbeispielen ist auch eine Positionierung des Temperatursensors T1 auf dem Kühlkörper 6 ausführbar. Dabei treten natürlich andere Werte für Geräteparameter im Temperaturmodell auf.

Die Überwachung und Ansteuerung 1 hat zur Aufgabe, die Leistungshalbleiter 16 zu überwachen, damit sie nicht zu heiß werden. So werden sie vor einer Überhitzung, die zu einer Zerstörung oder Lebensdauerverringerung führen kann, geschützt. Der Schutz kann dabei wahlweise durch verschiedene Maßnahmen erfolgen. Beispielsweise wird die Betriebsfrequenz des Umrichters herabgesetzt und somit die Verlustleistung der Halbleiter reduziert. Reicht auch dies nicht aus, wird eine Fehlermeldung ausgelöst und/oder der Umrichter abgeschaltet.

Zur Bestimmung kritischer Werte für Auslösen des jeweiligen Schutzes sind bei verschiedenen erfindungsgemäßen Ausführungsbeispielen verschieden Temperaturmodelle einsetzbar. Beispielsweise wird mittels des Temperaturmodells eine theoretisch errechnete Temperaturdifferenz bestimmt und auf eine gemessene Temperatur, wie beispielsweise T1, addiert. Die so erhaltene Temperatur wird mit der anderen Temperatur, wie beispielsweise T2, verglichen. Bei Abweichungen, die ein kritisches Maß überschreiten, wird eine der obengenannten Schutzmaßnahmen ausgelöst. T1 und T2 können bei der Addition und diesem Vergleich auch vertauscht werden.

Das Verfahren beruht also auf dem Vergleich der errechneten Temperatur, die sich aus der Verlustleistung eines mit einem Kühlkörpers 6 gekühlten Bauelementes unter Berücksichtigung der Umgebungstemperatur und der Geräte- und Betriebsparameter ergibt, mit der tatsächlich gemessenen Temperatur.

Das Temperaturmodell ist in einem weiteren erfindungsgemäßen Ausführungsbeispiel als Hardware, Software oder in einer geeigneten Mischung ausführbar. Ebenso ist die zugehörige Auswerteelektronik oder das Auswerteprogramm zum Auslösen der Schutzmaßnahmen ausführbar. Dieses Programm kann auch Bestandteil der Betriebssoftware des Frequenzumrichters sein. Es berechnet, vergleicht und wertet aus:
a) Aus den Geräte- und Betriebsparametem wird die Verlustleistung der Leistungshalbleiter 16 errechnet.
b) Aus den Geräteparametern des Kühlkörpers 6 und der errechneten Verlustleistung der Leistungshalbleiter 16 wird die Temperaturdifferenz, die sich am Kühlkörper 6 einstellen sollte, errechnet.
c) Durch die Addition der Umgebungstemperatur, die über den Temperatursensor T2 gemessen wird, mit der errechneten Temperaturdifferenz wird eine Solltemperatur für T1 ermittelt. Dabei wird unter Umgebungstemperatur, die Temperatur der direkten Umgebung des Umrichters, also beispielsweise die Temperatur der Zuluft oder der Luft, die auf den Kühlkörper zugeführt wird, verstanden.
d) Ein weiterer Teil der Auswerteelektronik oder des Auswertesoftware vergleicht die bei den Leistungshalbleitern 16 über den Temperatursensor T1 gemessene Temperatur mit der errechneten Solltemperatur.
e) Zur Auswertung und zum Auslösen der Schutzmaßnahmen für die Leistungshalbleiter 16 werden die Differenz zwischen der gemessenen Temperatur T1 und der Solltemperatur und die thermischen Zeitkonstanten der gesamten Vorrichtung berücksichtigt.
Über die Auswertung hinaus ist auch ein Abgeben von bloßen Warnungen möglich, die der Überwachung des Systems dienen. Wenn nämlich die Temperatur T1 größer ist als die Solltemperatur, kann das folgenden Gründe haben:
1) Der Kühlkörper ist derart verschmutzt, dass die Wärmeabgabe sich merklich verschlechtert hat.
2) Der Lüfter ist defekt, weshalb der Kühlkörper nicht die Nenn-Kühlleistung erbringt.
3) Mindestens ein Leistungshalbleiter 16 hat größere Verluste als errechnet, weil er beispielsweise schlecht gefertigt ist, fertigungs- oder alterungsbedingt einen schlechten Wärmeübergangswiderstand zum Kühlkörper hin aufweist oder am Ende seiner Lebensdauer ist.
4) Die Ansteuerung 2 arbeitet nicht ordnungsgemäß.
5) Der Wärmeübergang zwischen Halbleiter und Kühlkörper verschlechtert sich.

Für die Punkte 1) bis 5) wird also von der Überwachung und Auswertung 1 eine Wartungsmeldung oder Warnmeldung 9 hörbar, sichtbar oder elektronisch, insbesondere über Feldbus an eine zentrale Steuerung ausgelöst. Somit ist die Wartung einfach und schnell ausführbar. Für einige Punkte ist ein Auswechseln des Gerätes durchzuführen, um das Kühlsystem zu überprüfen, um den Totalausfall rechtzeitig zu verhindern oder das Gerät noch reparieren zu können.

Darüber hinaus ist auch eine bessere Auslastung und sogar zeitliche Prädiktion ausführbar. Wenn beispielsweise die Temperatur der Leistungshalbleiter kleiner als die errechnete Solltemperatur ist, ist das ein Anzeichen dafür, dass ein Bauelement, wie Leitungshalbleiter, Substrat, Wärmeübergang, Kühlkörper, Lüfter oder dergleichen, in der entsprechenden Übertragungskette besser als erwartet ist oder bei der Konstruktion die Auslegung mit großen Sicherheitszuschlägen erfolgte. Somit ist der Umrichter zum Abgeben größerer Leistung betreibbar. Außerdem sind sogar bei bekannten oder gemessenen Zeitkonstanten kurzzeitig sehr hohe Leistungen abgebbar, da mittels eines um Vorausberechnung verbesserten Temperaturmodells bessere Abschätzungen des Temperaturverlaufs der Leistungshalbleiter ausgeführt werden.

## Patentansprüche

1. Verfahren für eine Vorrichtung mit Leistungshalbleitern (16) insbesondere für einen Umrichter (10)
bei dem eine Temperatur (T1,T2) einer mit den Leistungshalbleitern gut wärmeleitend verbundenen Komponente der Vorrichtung und/oder der Umgebung und/oder der Zuluft (15) direkt oder indirekt ermittelt wird
und bei dem ein Temperaturmodell verwendet wird, das die Temperatur (T2) der Umgebung eines Kühlkörpers und/oder Zuluft (15) für den Kühlkörper, einen Betriebsparameter und einen Geräteparameter berücksichtigt und eine Temperaturdifferenz und/oder Temperatur errechnet,
wobei Aktionen gestartet werden, wenn die errechnete Temperatur und/oder Temperaturdifferenz mindestens einen vorgebbaren oder vorgegebenen Schwellwert überschreitet,
**dadurch gekennzeichnet, dass**
für das Temperaturmodell eine erste Temperatur (T1) an einer ersten Position in der Vorrichtung mit einem ersten Temperatursensor ermittelt wird und
eine zweite Temperatur (T2) an einer zweiten Position mit einem zweiten Temperatursensor ermittelt wird und
die erste und zweite Position derart gewählt ist, dass die erste Position einen geringeren Wärmeleitwiderstand zu den Leistungshalbleitern (16) jeweils aufweist als der Wärmeleitwiderstand von der zweiten Position zu den Leistungshalbleitern (16) jeweils,
wobei die Aktionen Abschaltung und/oder Maßnahmen zur Abkühlung und/oder Begrenzung eines weiteren Temperaturanstiegs umfassen und/oder das Abgeben von Warnmeldungen (9) umfassen.

2. Verfahren nach Anspruch 1,
**dadurch gekennzeichnet, dass**
eine errechnete Temperatur mit einer gemessenen Temperatur (T1,T2) verglichen wird und bei Überschreiten oder Unterschreiten eines Bereichs um die gemessene Temperatur herum die Aktionen gestartet werden.

3. Verfahren nach mindestens einem der vorangegangenen Ansprüche,
**dadurch gekennzeichnet, dass**
aus dem Vergleich der errechneten Temperatur, die sich durch Berücksichtigung der Verlustleistung der Leistungshalbleiter (16) und unter Berücksichtigung der Betriebsparameter und der Umgebungstemperatur ergibt, mit der tatsächlich gemessenen Temperatur (T1, T2) mindestens ein Kriterium zum Auslösen von Aktionen hergeleitet wird.

4. Verfahren nach mindesten einem der vorangegangenen Ansprüche,
**dadurch gekennzeichnet, dass**
die Wammeldungen (9) elektronisch, elektronisch über einen Feldbus, optisch, akustisch und/oder elektromagnetisch abgegeben werden.

5. Verfahren nach mindesten einem der vorangegangenen Ansprüche,
**dadurch gekennzeichnet, dass**
die zweite Position derart gewählt ist, dass im Wesentlichen die Temperatur der Umgebung oder Temperatur der Zuluft (15) insbesondere bei Einsatz eines Lüfters (7), mit dem zweiten Temperatursensor (T2) gemessen wird.

6. Verfahren nach mindesten einem der vorangegangenen Ansprüche,
**dadurch gekennzeichnet, dass**
- im Temperaturmodell aus Betriebsparametem und Geräteparametem die Verlustleistung der Leistungshalbleiter (16) errechnet wird,
- aus den Geräteparametem des Kühlkörpers (6) und der errechneten Verlustleistung des Leistungshalbleiters 16 die Temperaturdifferenz, die sich am Kühlkörper (6) einstellen sollte, errechnet wird,
- durch Addition der zweiten Temperatur und der errechneten Temperaturdifferenz eine Solltemperatur ermittelt wird und
- die erste Temperatur (T1) mit der errechneten Solltemperatur verglichen wird.

7. Verfahren nach mindesten einem der vorangegangenen Ansprüche,
**dadurch gekennzeichnet, dass**
mittels dieses Vergleichs unter Berücksichtigung der thermischen Zeitkonstanten der Vorrichtung eine Überwachung der Vorrichtung durchgeführt wird.

8. Vorrichtung mit Leistungshalbleitern (16), insbesondere Umrichter (10), zur Durchführung des Verfahrens nach einem der vorangegangenen Ansprüche,
wobei ein Temperatursensor (T1,T2) zur Erfassung von Temperaturen einer mit den Leistungshalbleitern (16) gut wärmeleitend verbundenen Komponente der Vorrichtung und/oder der Umgebung und/oder der Zuluft (15) vorgesehen ist,
und bei dem Hardware, Software und/oder eine Mischung hieraus zur Ausführung eines Temperaturmodells vorgesehen sind, bei dem die Temperatur (T2) der Umgebung eines Kühlkörpers (6) und/oder Zuluft (15) für den Kühlkörper (6) einen Betriebsparameter und einen Geräteparameter berücksichtigbar ist und eine Temperaturdifferenz und/oder Temperatur errechenbar ist,
wobei Mittel zum Ausführen von Aktionen vorgesehen sind, die bei Überschreitung mindestens eines vorgebbaren oder vorgegebenen Schwellwerts durch die errechnete Temperatur und/oder Temperaturdifferenz startbar sind,
**dadurch gekennzeichnet, dass**
eine erste Temperatur an einer ersten Position in der Vorrichtung mit einem ersten Temperatursensor (T1) messbar ist und
eine zweite Temperatur an einer zweiten Position mit einem zweiten Temperatursensor (T2) messbar ist und
die erste und zweite Position derart gewählt ist, dass die erste Position einen geringeren Wärmeleitwiderstand zu den Leistungshalbleitern (16) jeweils aufweist als der Wärmeleitwiderstand von der zweiten Position zu den Leistungshalbleitern (16) jeweils.
wobei die Mittel zum Ausführen der Aktionen Mittel zur Abschaltung und/oder zur Ausführung von Maßnahmen zur Abkühlung und/oder Begrenzung eines weiteren Temperaturanstiegs umfassen und/oder Mittel zum Abgeben von Warnmeldungen (9) umfassen.

## Claims

1. A method for a device with power semiconductors (16), in particular for an inverter (10),
in which a temperature **(T1, T2)** of a component of the device connected in a good thermally conducting manner to the power semiconductors and/or of the surroundings and/or of the air supplied (15) is determined directly or indirectly,
and in which a temperature model is used which takes into consideration the temperature **(T2)** of the surroundings of a heat sink and/or the air supplied (15) for the heat sink, an operating parameter and an appliance parameter and calculates a temperature difference and/or temperature,
wherein actions are started if the calculated temperature and/or temperature difference exceeds at least one pre-determinable or pre-determined threshold value,
**characterized in that**
for the temperature model a first temperature (**T1**) is determined at a first position in the device with a first temperature sensor and
a second temperature **(T2)** is determined at a second position with a second temperature sensor, and
the first and second positions are selected in such a way that the first position has a lower thermal-conductivity resistance with respect to the power semiconductors (16) in each case than the thermal-conductivity resistance of the second position with respect to the power semiconductors (16) in each case,
wherein the actions comprise switching off and/or steps for cooling and/or limiting a further temperature increase and/or comprise the issuing of warning notices (9).

2. A method according to Claim 1, **characterized in that** a calculated temperature is compared with a measured temperature **(T1, T2),** and if a range around the measured temperature is exceeded or not reached then the actions are started.

3. A method according to at least one of the preceding Claims, **characterized in that** at least one criterion for initiating actions is derived from the comparison of the calculated temperature, which results from taking into consideration the power loss of the power semiconductors (16) and whilst taking into consideration the operating parameters and the surrounding temperature, with the temperature (**T1, T2**) actually measured.

4. A method according to at least one of the preceding Claims, **characterized in that** the warning notices (9) are issued electronically, electronically by way of a field bus, optically, acoustically and/or electromagnetically.

5. A method according to at least one of the preceding Claims, **characterized in that** the second position is selected in such a way that the temperature of the surroundings or the temperature of the air supplied (15), in particular when using a fan (7), is essentially measured by the second temperature sensor **(T2)**.

6. A method according to at least one of the preceding Claims, **characterized in that**
- in the temperature model the power loss of the power semiconductors (16) is calculated from operating parameters and appliance parameters,
- the temperature difference which is to be set at the heat sink (6) is calculated from the appliance parameters of the heat sink (6) and the calculated power loss of the power semiconductor (16),
- a nominal temperature is determined by the addition of the second temperature and the calculated temperature difference, and
- the first temperature (**T1**) is compared with the calculated nominal temperature.

7. A method according to at least one of the preceding Claims, **characterized in that** a monitoring of the device is carried out by means of the said comparison whilst taking into consideration the thermal time constants of the device.

8. A device with power semiconductors (16), in particular an inverter (10), for performing the method according to one of the preceding Claims,
wherein a temperature sensor (**T1, T2**) is provided for detecting temperatures of a component of the device connected in a good thermally conducting manner to the power semiconductors (16) and/or of the surroundings and/or of the air supplied (15),
and in which hardware, software and/or a mixture of them is provided for producing a temperature model, in which the temperature **(T2)** of the surroundings of a heat sink (6) and/or of the air supplied (15) for the heat sink (6), an operating parameter and an appliance parameter is capable of being taken into consideration and a temperature difference and/or a temperature is capable of being calculated,
wherein means are provided for performing actions which are capable of being started if at least one pre-determinable or pre-determined threshold value is exceeded by the calculated temperature and/or temperature difference,
**characterized in that**
a first temperature is capable of being measured at a first position in the device with a first temperature sensor (**T1**) and
a second temperature is capable of being measured at a second position with a second temperature sensor **(T2)** and
the first and second positions are selected in such a way that the first position has a lower thermal-conductivity resistance with respect to the power semiconductors (16) in each case than the thermal-conductivity resistance of the second position with respect to the power semiconductors (16) in each case,
wherein the means for performing the actions comprise means for switching off and/or for performing steps for cooling and/or limiting a further temperature increase and/or comprise means for the issuing of warning notices (9).

## Revendications

1. Procédé pour un dispositif avec des semi-conducteurs de puissance (16), en particulier pour un variateur de vitesse (10),
dans lequel on détermine directement ou indirectement une température (T1, T2) d'un composant du dispositif et/ou de l'environnement et/ou de l'air amené (15) relié aux semi-conducteurs de puissance par une liaison bonne conductrice de la chaleur
et dans lequel on utilise un modèle de température qui tient compte de la température (T2) de l'environnement d'un radiateur et/ou de l'air amené (15) pour le radiateur, d'un paramètre de fonctionnement et d'un paramètre d'appareil et qui calcule une différence de température et/ou une température,
des actions étant déclenchées lorsque la température et/ou la différence de température calculée dépasse au moins une valeur seuil définissable ou définie,
**caractérisé par le fait que**
l'on détermine pour le modèle de température une première température (T1) à une première position dans le dispositif avec une première sonde de température et
l'on détermine une deuxième température (T2) à une deuxième position avec une deuxième sonde de température et
l'on choisit la première et la deuxième position de façon que la première position présente chaque fois une plus faible inertie thermique par rapport aux semi-conducteurs de puissance (16) que l'inertie thermique de la deuxième position par rapport aux semi-conducteurs de puissance (16),
les actions comprenant la coupure et/ou des mesures en vue du refroidissement et/ou de la limitation d'une nouvelle augmentation de température et/ou la délivrance de messages d'avertissement (9).

2. Procédé selon la revendication 1,
**caractérisé par le fait que**
l'on compare une température calculée avec une température mesurée (T1, T2) et que l'on déclenche les actions en cas de dépassement ou de sous-dépassement d'une plage autour de la température mesurée.

3. Procédé selon au moins l'une des revendications précédentes,
**caractérisé par le fait que**
l'on déduit de la comparaison de la température calculée, obtenue par prise en compte de la dissipation de puissance des semi-conducteurs de puissance (16) et par prise en compte des paramètres de fonctionnement et de la température ambiante, avec la température effectivement mesurée (T1, T2) au moins un critère pour le déclenchement des actions.

4. Procédé selon au moins l'une des revendications précédentes,
**caractérisé par le fait que**
les messages d'avertissement (9) sont délivrés par voie électronique, électronique via un bus de terrain, optique, acoustique et/ou électromagnétique.

5. Procédé selon au moins l'une des revendications précédentes,
**caractérisé par le fait que**
l'on choisit la deuxième position de façon que la température de l'environnement ou la température de l'air amené (15), en particulier en cas d'utilisation d'un ventilateur (7), soit essentiellement mesurée avec la deuxième sonde de température (T2).

6. Procédé selon au moins l'une des revendications précédentes,
**caractérisé par le fait que**
- l'on calcule dans le modèle de température, à partir des paramètres de fonctionnement et des paramètres d'appareil, la dissipation de puissance des semi-conducteurs de puissance (16),
- l'on calcule à partir des paramètres d'appareil du radiateur (6) et de la dissipation de puissance des semi-conducteurs de puissance (16) calculée la différence de température qui devrait s'établir au radiateur (6),
- l'on détermine par addition de la deuxième température et de la différence de température calculée une température théorique et
- l'on compare la première température (T1) avec la température théorique calculée.

7. Procédé selon au moins l'une des revendications précédentes,
**caractérisé par le fait que**
l'on effectue au moyen de cette comparaison, en tenant compte des constantes de temps thermiques du dispositif, une surveillance du dispositif

8. Dispositif avec des semi-conducteurs de puissance (16), en particulier un variateur de vitesse (10), pour réaliser le procédé selon l'une des revendications précédentes,
dans lequel il est prévu une sonde de température (T1, T2) pour saisir la température d'un composant du dispositif et/ou de l'environnement et/ou de l'air amené (15) relié aux semi-conducteurs de puissance (16) par une liaison bonne conductrice de la chaleur
et dans lequel il est prévu du matériel, du logiciel ou un mélange des deux pour réaliser un modèle de température dans lequel on peut tenir compte de la température (T2) de l'environnement d'un radiateur (6) et/ou de l'air amené (15) pour le radiateur (6), d'un paramètre de fonctionnement et d'un paramètre d'appareil et on peut calculer une différence de température et/ou une température,
et dans lequel il est prévu des moyens pour l'exécution d'actions qui sont déclenchables en cas de dépassement d'une valeur seuil définissable ou définie par la température et/ou la différence de température calculée,
**caractérisé par le fait que**
l'on peut mesurer une première température à une première position dans le dispositif avec une première sonde de température (T1) et
l'on peut mesurer une deuxième température à une deuxième position avec une deuxième sonde de température (T2) et
l'on choisit la première et la deuxième position de façon que la première position présente chaque fois une plus faible inertie thermique par rapport aux semi-conducteurs de puissance (16) que l'inertie thermique de la deuxième position par rapport aux semi-conducteurs de puissance (16),
les moyens pour l'exécution d'actions comprenant des moyens pour la coupure et/ou pour l'exécution de mesures en vue du refroidissement et/ou de la limitation d'une nouvelle augmentation de température et/ou des moyens pour la délivrance de messages d'avertissement (9).
